# EUROPEAN PATENT SPECIFICATION

(11) **EP 2 814 996 B1**
(45) Date of publication and mention of the grant of the patent: **26.12.2018**
(21) Application number: 13749430.8
(22) Date of filing: 12.02.2013
(51) Int. Cl.: C23C 16/455, C23C 16/44

(54) **NOZZLE AND NOZZLE HEAD**
DÜSE UND DÜSENKOPF
BUSE ET TÊTE DE BUSE

(30) Priority: 17.02.2012 FI 20125186
(43) Date of publication of application: 24.12.2014
(73) Proprietor: Beneq OY, 02200 Espoo (FI)
(72) Inventor: ALASAARELA, Tapani, FI-02200 Espoo (FI); SOININEN, Pekka, FI-02200 Espoo (FI); JAUHIAINEN, Mika, FI-02200 Espoo (FI)
(74) Representative: Nuppola, Anna Marjukka
(86) International application number: PCT/FI2013/050154
(87) International publication number: WO 2013/121102

(56) References cited:
- WO-A1-2008/130369
- US-A1- 2009 304 924
- US-A1- 2010 037 820

## Description

### FIELD OF THE INVENTION

The present invention relates to a nozzle for subjecting a surface of a substrate to a gaseous precursor and particularly to a nozzle head according to the preamble of claim 1. The present invention further relates to a nozzle head for subjecting a surface of a substrate to successive surface reactions of at least a first precursor and a second precursor, and particularly to a nozzle head according to the preamble of claim 7.

### BACKGROUND OF THE INVENTION

In the prior art several types of apparatuses, nozzle heads and nozzles are used for subjecting a surface of a substrate to successive surface reactions of at least a first precursor and a second precursor according to the principles of atomic layer deposition method (ALD). In ALD applications, typically two gaseous precursors are introduced into the ALD reactor in separate stages. The gaseous precursors effectively react with the substrate surface, resulting in deposition of a growth layer. The precursor stages are typically followed or separated by an inert-gas purge stage that eliminates the excess precursor from the surface of the substrate prior to the separate introduction of the other precursor. Therefore an ALD process requires alternating in sequence the flux of precursors to the surface of the substrate. This repeated sequence of alternating surface reactions and purge stages between is a typical ALD deposition cycle.

The prior art apparatuses for continuously operating ALD usually comprise a nozzle head having precursor nozzles arranged successively adjacent to each other such that the surface of the substrate may be subjected successively to surface reaction of at least a first and second precursors. The nozzles provide one or more first precursor supply channels for supplying the first precursor and one or more second precursor supply channels for supplying the second precursor. A nozzle head is usually also provided with one or more purge gas channels and one or more discharge channels for discharging both precursors and purge gas. In one prior art nozzle head the channels are arranged in the following order: at least a first precursor nozzle, a first discharge channel, purge gas channel, a discharge channel, a second precursor nozzle, a discharge channel, a purge gas channel and a discharge channel, optionally repeated a plurality of times.

The problem with this prior art nozzle head is that it comprises several different nozzles and channels which makes the nozzle head complicated and rather large. When the surface of the substrate is processed the nozzles and the nozzle head are moved in relation to the substrate such that the nozzles and nozzle head scan over the surface of the substrate subjecting the substrate surface successively to the different precursors. In industrial applications it is advantageous to form as many ALD cycles as possible with one scan. The prior art nozzles and nozzle heads do not provide compact and effective constructions for industrial scale apparatuses.

Publication US 2009/0304924 discloses an apparatus and method for large area high speed atomic layer chemical vapor processing and publication US 2010/037820 discloses a vapor deposition reactor.

### BRIEF DESCRIPTION OF THE INVENTION

The object of the present invention is to provide a nozzle and a nozzle head such that the above mentioned prior art problems are solved or at least alleviated. The objects of the present invention are achieved with a nozzle according to the independent claim 1, in which a precursor supply element is arranged to extend inside a discharge channel such that the precursor supply element divides the discharge channel in the longitudinal direction to a first discharge sub-channel and a second discharge sub-channel on opposite sides of the precursor supply element for supplying precursor through the discharge channel. The objects of the present invention are further achieved with a nozzle head according to the independent claim 7, in which at least one of first and second precursor supply channels is arranged to supply precursor through a discharge channel for dividing the discharge channel in the longitudinal direction to a first discharge sub-channel and a second discharge sub-channel on opposite sides of the precursor supply channel.

The preferred embodiments of the present invention are described in dependent claims.

The invention is based on the idea of supplying the gaseous precursor material through a discharge channel such that a discharge sub-channel is formed on opposite sides of the precursor supply. The present invention provides a nozzle comprising an output face via which the precursor is supplied, a precursor supply element for supplying precursor and a longitudinal discharge channel open to and along the output face for discharging at least a fraction of the precursor supplied from the precursor channel. According to the present invention the precursor supply element is arranged to extend inside the discharge channel such that the precursor supply element divides the discharge channel in the longitudinal direction to a first discharge sub-channel and a second discharge sub-channel on opposite sides of the precursor supply element for supplying precursor through the discharge channel. Therefore the present invention provides a nozzle in which the precursor supply channel is arranged inside a discharge channel and the precursor is supplied through the discharge channel. This nozzle arrangement may further be used in a nozzle head having an output face and comprising one or more first longitudinal precursor supply channels for subjecting the surface of the substrate to the first precursor via the output face, one or more second longitudinal precursor supply channels for subjecting the surface of the substrate to the second precursor via the output face, and one or more longitudinal discharge channels open to the output face for discharging at least a fraction of the first and second precursor supplied from the first and second precursor supply channels. In the nozzle head at least one of the first and second precursor supply channels is arranged to supply precursor through a discharge channel for dividing the discharge channel in the longitudinal direction to a first discharge sub-channel and a second discharge sub-channel on opposite sides of the precursor supply channel. Therefore at least one of the first and second precursor supply channels may be arranged inside a discharge channel for dividing the discharge channel in the longitudinal direction to a first discharge sub-channel and a second discharge sub-channel on opposite sides of the precursor supply channel.

An advantage of the nozzle and nozzle head of the present invention is a compact structure in which the discharge channel and the precursor supply channel are nested. This eliminates the need for separate discharge channels and precursor supply channels. Furthermore, a single discharge channel is arranged to form a discharge sub-channel on both sides of the precursor supply channel instead of two separate discharge channels. Therefore, the nozzle and nozzle head is simpler in structure and more compact. This means that a larger number of precursor supply channels may be formed on a certain surface area of the output face of the nozzle head and further growth layers may be produces on the substrate surface with one scan.

### BRIEF DESCRIPTION OF THE DRAWINGS

In the following the invention will be described in greater detail by means of preferred embodiments with reference to the attached drawings, in which
figure 1 shows a schematic view of a nozzle head according to the present invention;
figure 2 shows a schematic view of another nozzle head according to the present invention;
figure 3 shows a schematic view of one embodiment of a nozzle according to the present invention;
figure 4 shows a schematic view of a nozzle head comprising nozzles of figure 3 arranged next to each other;
figure 5 shows a schematic view of another embodiment of a nozzle according to the present invention;
figure 6 shows a schematic view of another nozzle head according to the present invention;
figure 7 shows a schematic view of still another nozzle head according to the present invention;
figure 8 shows a schematic view of still another embodiment of a nozzle according to the present invention; and
figure 9 shows a schematic view of yet another embodiment of a nozzle according to the present invention.

### DETAILED DESCRIPTION OF THE INVENTION

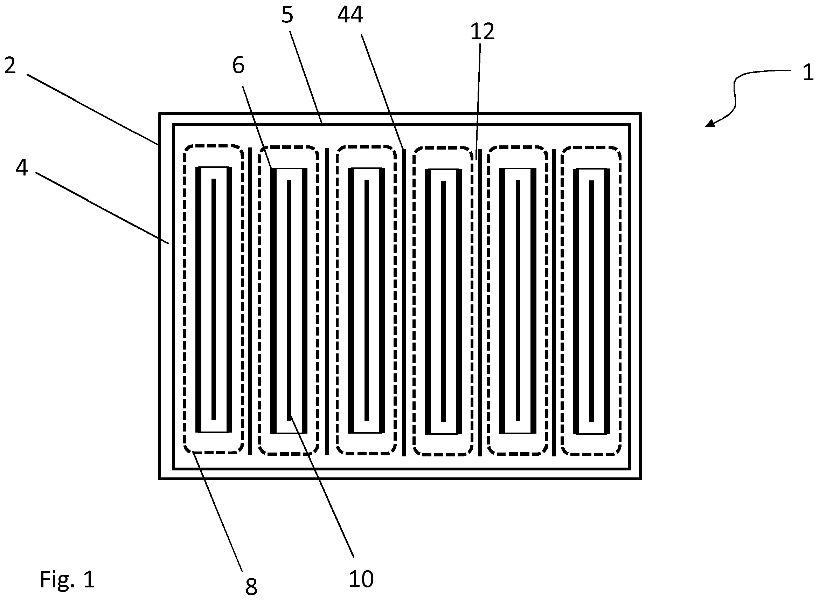

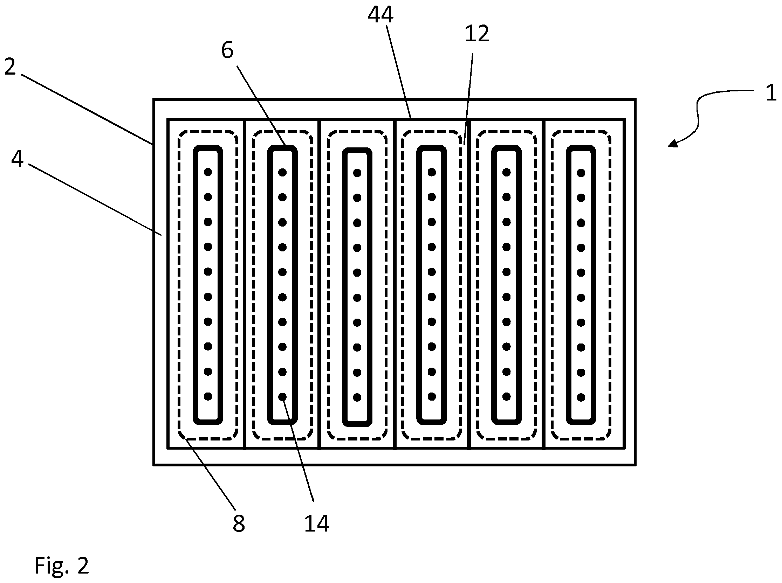

Figure 1 shows schematically one embodiment of a nozzle head 1 according to the present. The nozzle head 1 comprises nozzle head body 2 and a nozzle head output face 4 via which the gaseous precursors are supplied. In the embodiment of figure 1 the nozzle head output face 4 is planar, but in an alternative embodiment it may also be non-planar, curved, cylindrical or have any other suitable form. The nozzle head 1 is provided with nozzles 8 arranged adjacently to each other and extending longitudinally along the output face 4. The nozzles 8 are shown with dashed lines in figures 1 and 2. The nozzles 8 are separated with a distance or gap 12 from each other. The nozzles 8 comprise a discharge channel 6 and a precursor supply channel 10 arranged inside the discharge channel 6. In this embodiment the discharge channel 6 and the precursor supply channel 10 are formed as longitudinal channels. As shown in figure 1 the precursor supply channel 10 divides the discharge channel 6 into two discharge sub-channels in the longitudinal direction, one on each side of the precursor supply channel 10 for discharging at least a fraction of the supplied precursor. In a preferred embodiment the discharge channel 6 and the precursor supply channel 10 flush with the nozzle head output face 4. Alternatively the discharge channel 6 and/or the precursor supply channel may protrude from the nozzle head output face 4 or may be partly below the nozzle head output face 4. It should be noted that the nozzles 8 may be integral parts of the nozzle head 1 and the nozzle head body 2 or alternatively they may be detachable parts which may be removed or replaced. The gap 12 between the nozzles 8 is in this embodiment provided with a purge gas channel 44 for supplying purge gas, such as nitrogen. The purge gas channels are preferably longer than the nozzles 8 or the precursor supply channels. The purge gas channel 44 is provided for separating the adjacent nozzles 8 and the precursors from each other and for purging the surface of the substrate. The nozzle head output face 4 is further provided with discharge perimeter 5, which surrounds the nozzles 8 and the purge gas channels 44. The discharge perimeter 5 is connected to vacuum pump or the like such that it may discharge precursors and purge gas from the nozzle head output face 4. In this embodiment the discharge perimeter 5 is continuous, but alternative it may be formed from two or more separate discharge channels parts arranged to surround the nozzles 8 and the purge gas channels 44. It should be noted that a purge gas perimeter (not shown) may also be arranged to the nozzle in the same way as the discharge perimeter 5. The purge gas perimeter is preferably provided on inner side of the discharge perimeter 5 on the nozzle head output face 4.

Figure 2 shows an alternative embodiment in which the precursor supply channel comprises several supply holes 14 extending and opening towards the nozzle head output face 4. The precursor supply channel 10 is furthermore arranged in the middle of the discharge channel 6 such that the discharge channel 6 surrounds the precursor supply channel 10 from all directions on the nozzle head output face 4. In other words the ends of the discharge channels 6 on the opposite sides of the precursor supply channel 6 are connected to form a discharge channel surrounding the precursor supply channel 10. Also in this embodiment the precursor supply channel divides the discharge channel 6 into two discharge sub-channels in the longitudinal direction, one on each side of the precursor supply channel. In addition, the ends of the discharge sub-channels connect to each other forming a circumferential discharge channel around the precursor supply channel on the nozzle head output face 4. In figures 1 and 2 the gap 12 between the nozzles 8 may be provided with a purge gas channel for supplying purge gas, such as nitrogen for purging the substrate surface. In the embodiment of figure 2, the purge channels 44 are connected to each other such that the purge gas channels 44 surround separately each nozzle 8 and also all the nozzles 8 on the nozzle head output face 4. It should be noted that the purge gas channels 44 also be arranged to surround only each nozzle 8 separately or only all the nozzles 8. When the purge gas channels 44 are arranged to surround the nozzles 8 the surrounding discharge perimeter 5, shown in figure 1, may be omitted. However, the discharge perimeter 5 may also be provided on the nozzle head output face 4 surrounding the connected purge gas channels 44.

It should be noted that the same structural parts are denoted with same reference numerals in figures 1 to 8.

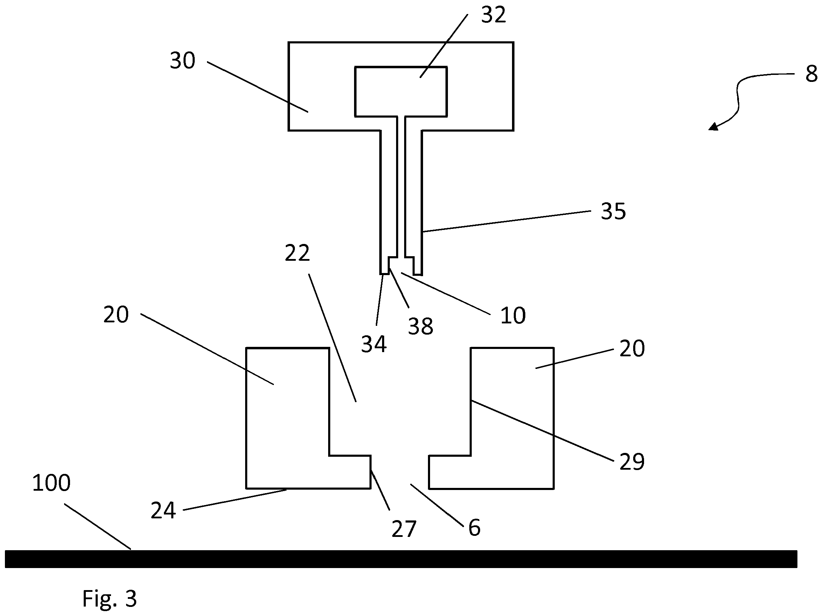

Figure 3 shows one embodiment the nozzle 8 according to the present invention. The nozzle 8 comprises a nozzle body 20 and a precursor supply element 30 for supplying precursor on the surface of a substrate 100. In figure 3 the nozzle 8 is shown disassembled such that the precursor supply element 30 is out of the nozzle body 20. Thus in this embodiment the precursor supply element 30 and the nozzle body 20 are separate parts, but in alternative embodiment they may also be integral parts. Therefore, the precursor supply element 30 may be integral part of the body 20 or a separate part. The nozzle body 20 comprises a nozzle output face 24 via which the precursor is supplied. The nozzle body 20 further comprises a longitudinal discharge channel 6 open to and along the nozzle output face 24. The discharge channel 6 has side walls 27 extending the longitudinal direction of the discharge channel 6. The nozzle body 20 further comprises a discharge conduit 22 extending substantially parallel and in fluid connection with the discharge channel 6 for exhausting discharged material from the discharge channel 6. Accordingly the nozzle body 20 is arranged to form the discharge channel 6 and discharge conduit 22 having longitudinal walls 29. The width of the discharge conduit 22 is greater than the width of the discharge channel 22 for enhancing the discharge pressure. The discharge conduit 22 and the discharge channel 6 are connected to a suction device (not shown) for providing suction. In a preferred embodiment the suction may be arranged to one or both longitudinal ends or the discharge conduit 22 and/or discharge channel 6.

The precursor supply element 30 is arranged to be installed at least partly inside the nozzle body 20. The precursor supply element 30 comprises one or more longitudinal precursor supply channels 10 open to the nozzle output face 24 for supplying precursor via the output face 24. The precursor supply element 30 further comprises a precursor conduit 32 in fluid connection with the precursor supply channel 10 for conducting precursor to the precursor supply channel 10. In the embodiment of figure 3 the precursor supply channel 10 is formed as a longitudinal channel open to and along the output face 24 and extending a as channel from the precursor conduit 32 to the end face 34 of the precursor supply channel 10. The longitudinal precursor supply channel 10 comprises an expansion 38 in the vicinity of the output face 24 and the end face 34 for increasing the width of the longitudinal precursor channel 10 at the output face 24. The expansion spreads and uniforms the precursor supply to the substrate surface. The expansion 38 equalizes the precursor supply in the width direction of the precursor supply channel 10 and decelerates the supply rate of the precursors. The expansion 38 provides a pressure balancing structure when the nozzle 8 or the nozzle head 1 is arranged close to a substrate surface.

In an alternative embodiment the precursor supply element may comprise one or more one or more precursor supply holes 14 extending from the precursor conduit 32 and opening to the output face 24 for forming the precursor supply channel. These kinds of supply holes 14 may extend in a transversal direction in relation to the longitudinal direction of the discharge channel 6. The precursor supply holes 14 may form the supply channel or channels. Alternatively the precursor supply holes 14 extend between the precursor conduit 32 and the longitudinal precursor supply channel 10 open to and along the output face 24. In one embodiment the longitudinal expansion 38 may form the precursor supply channel 10 and the supply holes extend between the expansion 38 and the precursor conduit 32.

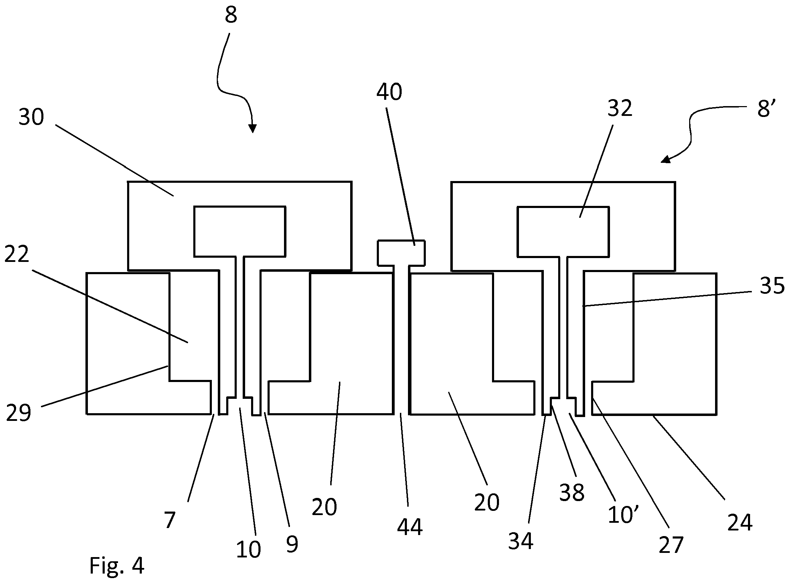

Figure 4 shows two nozzles 8, 8' of figure 3 are installed adjacently and assembled such that precursor supply element 30 is inside the nozzle body 20. The first nozzle 8 is arranged to supply a first precursor via the first precursor supply channel 10 and the second precursor 8' is arranged to supply second precursor via the second precursor supply channel 10'. Between the nozzles 8, 8' there is provided a purge gas element for supplying purge gas. The purge gas element comprises a purge gas conduit 40 and a purge gas supply channel 44 open to the nozzle output face 24. A nozzle head of figures 1 and 2 may be formed by arranging two or more nozzles 10, 10' adjacently.

A shown in figure 4, the precursor supply element 30 is arranged to extend through the discharge channel 6 to the output face 24. Thus the precursor supply element 30 is arranged to extend longitudinally inside the discharge channel 6 such that the precursor supply element 30 divides the discharge channel 6 in the longitudinal direction to a first discharge sub-channel 7 and a second discharge sub-channel 9 on opposite sides of the precursor supply element 30 for supplying precursor through the discharge channel 6. This means that the precursor is supplied from the nozzle 8, 8' through the discharge channel 6. In the embodiment of figure 4 the precursor supply element 30 is also arranged to extend through the discharge conduit 22 and the discharge channel 6 to the output face 24 such that the precursor channel 10 divides the discharge conduit 22 to two discharge sub-conduits on opposite sides of the precursor supply element 30. The precursor supply element 30 may be arranged to provide a fluid connection between the discharge sub-conduits of the discharge conduit 22. Alternatively there is no fluid connection between the discharge sub-conduits. The precursor supply element 30 is preferably arranged to extend inside the discharge channel 6 such that the end face 34 of the supply element 30 is substantially flush with the output face 24. The discharge sub-channels 7, 9 are thus formed between the outer wall 35 of the precursor supply channel 10 and the inner walls 27 of the discharge channel 6.

The nozzle 8, 8' of figure 4 enables one discharge channel 6 to be used for providing two discharge channels 7, 9 on opposite sides of the precursor supply channel 10, 10'. This also enables to use one suction device or suction connection for these both discharge sub-channels 7, 9. The precursors may be supplied to the precursor conduits 32 from the longitudinal ends of the precursor conduits 32. Furthermore, the present invention enables different precursors to be supplied from different ends to the longitudinal precursor conduits 32.

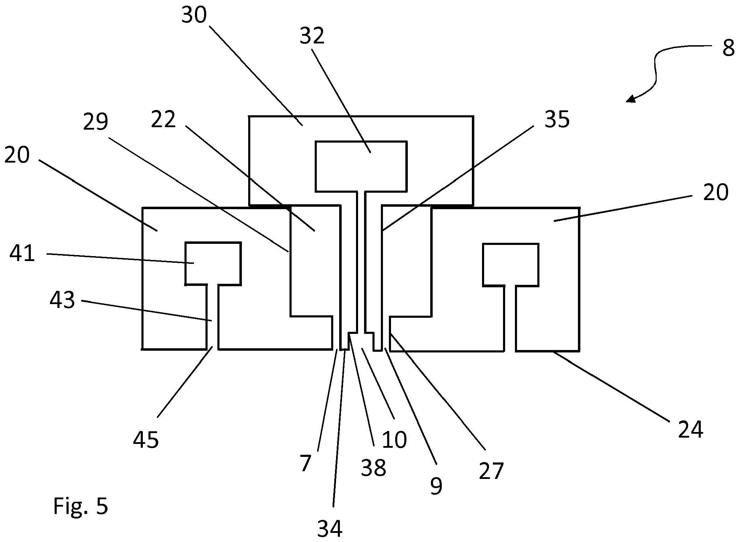

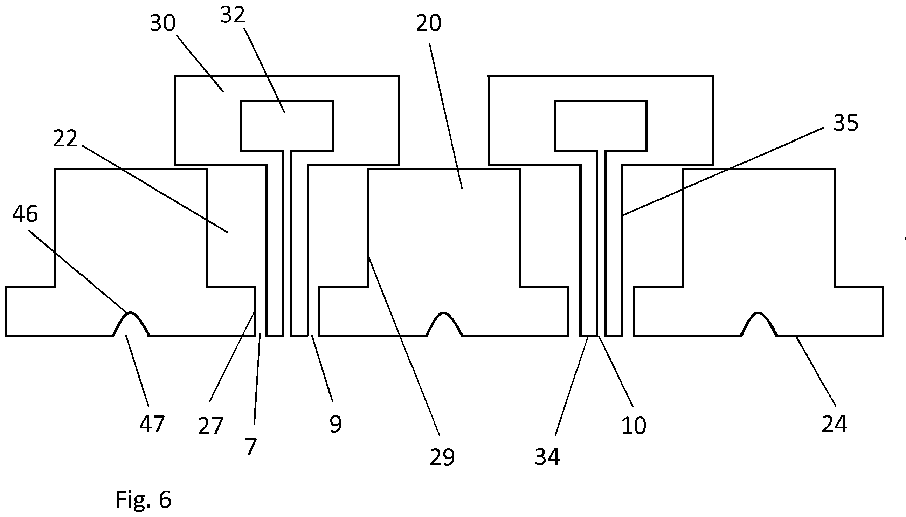

Figure 5 shows an alternative embodiment in which the purge gas channels 45 is formed to the nozzle body 20. The nozzle body 20 therefore comprises a purge gas conduit 41 and a purge gas supply channel open to the nozzle output face 24 and extending longitudinally substantially in the direction of the discharge channel 6. This purge gas arrangement provides an integral purge gas supply to the nozzle 8. Figure 6 shows an alternative embodiment in which a nozzle head is formed by arranging nozzles adjacent to each other. In this embodiment the nozzle body 20 comprises a purge gas channel 47 extending open to the nozzle output face 24 and extending longitudinally substantially in the direction of the discharge channel 6. In this embodiment one purge gas channel 47 is provided between two discharge channels 6 and between the discharge sub-channels 7 and 9. In this embodiment there is no expansion in the vicinity of the end face 34 of the precursor supply element 30. The nozzle head has a compact structure the nozzle body 20 or the nozzle head body 2 has only two different channels on the output face 4, 24, the purge gas channel 45, 47 and the discharge channel 6 as the precursor supply channel 10 is formed inside the discharge channel 6.

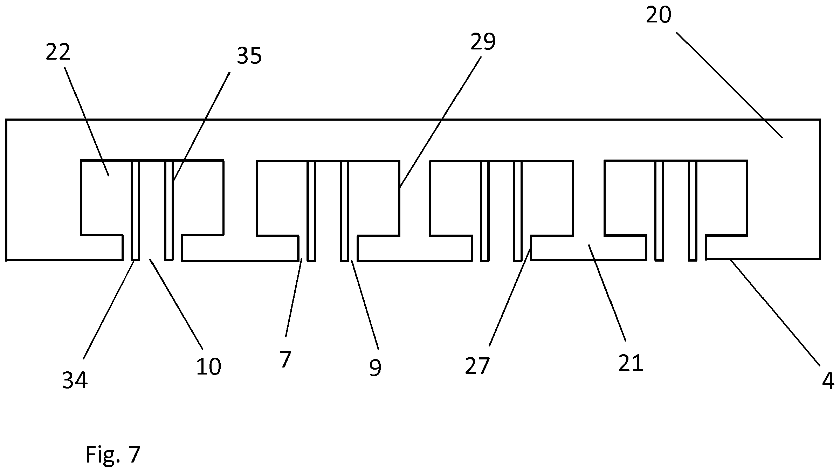

Figure 7 shows a nozzle head in which the nozzle head body 2 comprises discharge conduits 22 in fluid connection to the discharge channels 6. There is also a precursor supply channels 10 extending through the discharge conduit 22 and the discharge channel 6 to the nozzle head output face 4. In this embodiment the longitudinal discharge channels 6, discharge conduits 22 and the precursor supply channels 10 are formed as integral parts or machined shapes to the nozzle head body 2. The discharge channels and the discharge conduits 22 are separated from each other with partitioning walls 21. It should be noted as there is no precursor conduit in the embodiment of figure 7, also the discharge conduit 22 may be omitted or the discharge channel 6 may have uniform width also in the height direction.

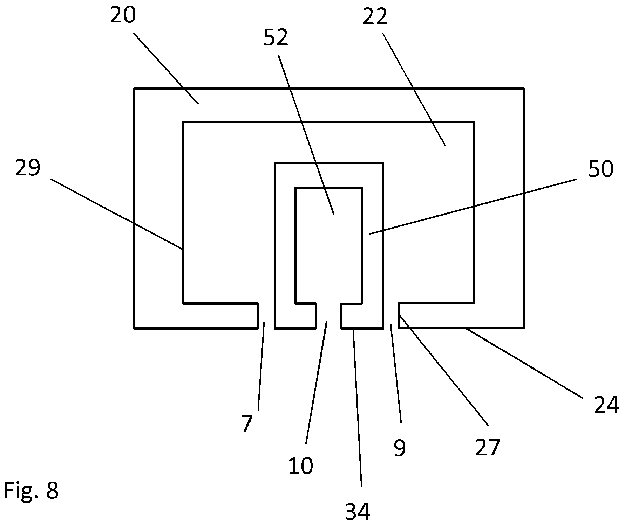

Figure 8 shows an alternative embodiment of the nozzle in which the precursor supply element 50 extends inside the discharge conduit 22 or discharge channel but not through the discharge conduit 22 in the height or width direction. Thus the precursor supply element 50 may provide a fluid connection between the first and second discharge sub-channels 7, 9. The precursor supply element 50 extends substantially in a nested fashion inside the discharge conduit 22 or the discharge channel 6, at least in the lateral direction of the discharge channel 6. In one embodiment the precursor supply element 50 may also extend substantially coaxially inside the discharge conduit 22 or the discharge channel 6, at least in the lateral direction of the discharge channel 6. The precursor supply element 50 comprises a precursor conduit 52 and a precursor supply channel 10 opening on and along the nozzle output face 24 such that it divides the discharge channel 6 into two discharge sub-channels 7, 9. The precursor supply element 50 is arranged to extend inside the discharge channel 6 such that the end face 34 the supply element 50 is substantially flush with the nozzle output face 24.

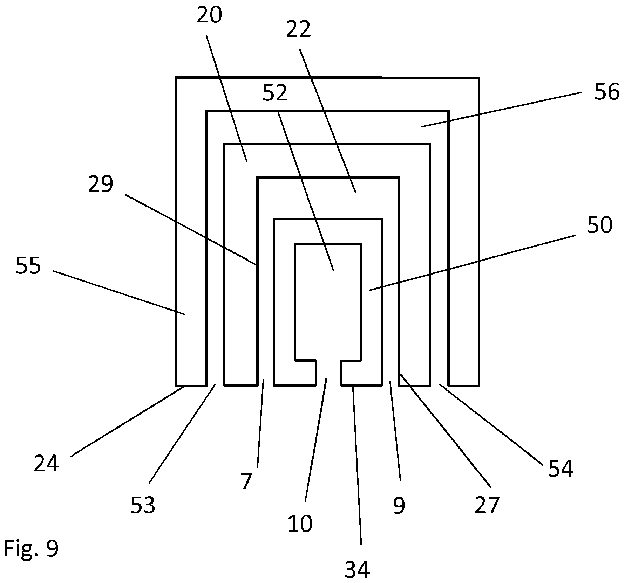

Figure 9 shows an alternative embodiment in which both the precursor supply channel 10 and the discharge channels 7, 9 are arranged to extend longitudinally inside the purge gas element 55 such that they divide the purge gas channel in the longitudinal direction to a first purge sub-channel 53 and a second purge gas sub-channel 54 on opposite sides of the precursor supply element 50 and the discharge channels 7, 9. The purge gas element also comprises a purge gas conduit 56 for supplying purge gas to the purge gas sub-channels 53, 54. In this embodiment the precursor supply element 50 and the nozzle body 20 forming the discharge channels 7, 9 are nested inside the purge gas element 55 and purge gas conduit 56. Thus there is fluid connection between the purge gas sub-channels 53, 54 via the purge gas conduit 56. The discharge conduit 22 may extends substantially in a nested fashion inside purge gas element 55. In one embodiment the discharge conduit 22 may also extend substantially coaxially inside the purge gas conduit 56, at least in the lateral direction of the discharge channels 7, 9. It should be noted the principle shown in figure 9 may also be applied to the nozzles and nozzle heads of figure 1 to 8. In other words the precursor supply channel and the discharge channel may be arranged inside the purge gas channel such that the precursor supply channel and the discharge channel divide the purge gas channel into first and second purge gas sub-channels 53, 54 on opposite side of the discharge channel and precursor supply channel. Therefore his principle may also be used in the nozzle structures shown in figures 3 to 8.

The present invention therefore provides a nozzle head in which nozzle 8, 8' described above may be used for subjecting a surface of a substrate to successive surface reactions of at least of first and second gaseous precursor for forming thin film on the surface of the substrate according to the principles of atomic layer deposition. 25. The nozzle described above may be used for subjecting a surface of a substrate to surface reaction a gaseous precursor.

The nozzle head of the present invention for subjecting a surface of a substrate 100 to successive surface reactions of at least a first gaseous precursor and a second gaseous precursor may comprise one or more first longitudinal precursor supply channels 10 for subjecting the surface of the substrate 100 to the first precursor via the nozzle head output face 4, one or more second longitudinal precursor supply channels 10' for subjecting the surface of the substrate 100 to the second precursor via the output face 4, and one or more longitudinal discharge channels 6 open to the output face 4 for discharging at least a fraction of the first and second precursor supplied from the first and second precursor supply channels 10, 10'. According to the present invention at least one of the first and second precursor supply channels 10, 10' is arranged to supply precursor through a discharge channel 6 for dividing the discharge channel 6 in the longitudinal direction to a first discharge sub-channel 7 and a second discharge sub-channel 9 on opposite sides of the precursor supply channel 10, 10'. In a preferred embodiment all the precursors are supplied through the discharge channels 6. Thus the first and second supply channels 10, 10' may be each arranged to supply precursor through a discharge channel 6, or that the first and second supply channels 10, 10' may be each arranged inside a discharge channel 6. Alternatively it is also possible that only one precursor channels is arranged according to the present invention.

Accordingly at least one of the first and second precursor supply channels 10, 10' of the nozzle head is arranged inside a discharge channel 6 for dividing the discharge channel 6 in the longitudinal direction to a first discharge sub-channel 7 and a second discharge sub-channel 9 on opposite sides of the precursor supply channel 10, 10'. This means that the first and second precursor supply channels 10, 10' may be arranged to extend through the discharge channel 6 to the nozzle head output face 4 in a direction transversal to the longitudinal direction of the discharge channel 6. The first and second precursor supply channels 10, 10' are arranged to extend inside and along the discharge channel 6. They may also be arranged to extend substantially coaxially inside and along the discharge channel 6, at least in the width direction of the discharge channel 6.

It will be obvious to a person skilled in the art that, as the technology advances, the inventive concept can be implemented in various ways. The invention and its embodiments are not limited to the examples described above but may vary within the scope of the claims.

## Claims

1. A nozzle (8) arranged to subject a surface of a substrate (100) to a gaseous precursor, the nozzle (8) comprising:
- an output face (24) via which the precursor is supplied;
- a precursor supply element (30, 50) for supplying precursor;
- a longitudinal discharge channel (6) open to and along the output face (24) for discharging at least a fraction of the precursor supplied from the precursor channel (10), and
- at least one purge gas channel (45, 47) open to the output face (24), wherein the nozzle (8) further comprises a body (20) forming the discharge channel (6), and the body further comprises a discharge conduit (22) extending substantially parallel and in fluid connection with the discharge channel (6) for exhausting discharged precursor from the discharge channel (6), that the precursor supply element (30, 50) is arranged to extend longitudinally inside the discharge channel (6) such that the precursor supply element (30, 50) divides the discharge channel (6) in the longitudinal direction to a first discharge sub-channel (7) and a second discharge sub-channel (9) on opposite sides of the precursor supply element (30, 50) for supplying precursor through the discharge channel (6), and that the precursor supply element (30, 50) is arranged to extend through the discharge conduit (22) such that the precursor channel (10) divides the discharge conduit (22) to two discharge sub-conduits on opposite sides of the precursor supply element (30, 50).

2. A nozzle according to claims 1, **characterized in that** the precursor supply element (30, 50) is integral part of the body (20) or a separate part.

3. A nozzle according to claim 1 or 2, **characterized in that** the precursor supply element (30, 50) comprises:
- one or more precursor supply channels (10, 14) open to the output face (24) for supplying precursor via the output face (24); and/or
- a precursor conduit (32, 52) in fluid connection with the precursor supply channel (10, 14) for conducting precursor to the precursor supply channel (10, 14); and/or
- an expansion (38) in the vicinity of the output face (24) for increasing the width of the longitudinal precursor channel (10) at the output face (24); and/or
- one or more precursor supply holes (14) extending from the precursor conduit (32, 52) and opening to the output face (24) for forming the precursor supply channel; and/or
- one or more precursor supply holes (14) extending from the precursor conduit (32, 52) and opening to the output face (24) for forming the precursor supply channel, the precursor supply holes (14) forming the supply channels, or the precursor supply holes (14) extending between the precursor conduit (32, 52) and the longitudinal precursor supply channel (10) open to and along the output face (24).

4. A nozzle according to any one of claims 1 to 3, **characterized in that**:
- the precursor supply element (30, 50) extends through the discharge channel (6) to the output face (24); or
- the precursor supply element (30) extends through the discharge conduit (22) and the discharge channel (6) to the output face (24) such that the precursor channel (10) divides the discharge conduit (22) to two discharge sub-conduits on opposite sides of the precursor supply element (30, 50).

5. A nozzle according to any one of claims 1 to 4, **characterized in that**:
- the precursor supply element (50) extends inside the discharge conduit (22) providing a fluid connection between the first and second discharge sub-channels (7, 9); and/or
- the precursor supply element (30, 50) is arranged to extend inside the discharge channel (6) such that the end face (34) of the supply element (30, 50) is substantially flush with the output face (24).

6. A nozzle according to claim 1, **characterized in that** the precursor supply channel (10) and the discharge channel (6) are arranged inside the purge gas channel (45, 47) such that the precursor supply channel (10) and the discharge channel (6) divide the purge gas channel (44, 47) into first and second purge gas sub-channels (53, 54) on opposite side of the discharge channel (6) and precursor supply channel (10).

7. A nozzle head (1) for subjecting a surface of a substrate (100) to successive surface reactions of at least a first gaseous precursor and a second gaseous precursor, the nozzle head (1) having an output face (4) and comprising:
- one or more first longitudinal precursor supply channels (10) for subjecting the surface of the substrate (100) to the first precursor via the output face (4); and
- one or more second longitudinal precursor supply channels (10') for subjecting the surface of the substrate (100) to the second precursor via the output face (4), and
- one or more longitudinal discharge channels (6) open to the output face (4) for discharging at least a fraction of the first and second precursor supplied from the first and second precursor supply channels (10, 10'), and
one or more purge gas channels (45, 47) for supplying purge gas to the surface of the substrate (100),
**characterized in that** the nozzle head (1) comprises one or more nozzles (8), which a nozzle (8) comprises a nozzle body (20) and a precursor supply element (30), the nozzle body (20) comprises a discharge channel (6) and a discharge conduit (22) extending substantially parallel and in fluid connection with the discharge channel (6) for exhausting discharged precursor from the discharge channel (6), and
the precursor supply element (30) comprises the one or more longitudinal precursor supply channels (10, 10'), and that
at least one of the first and second precursor supply channels (10, 10') is arranged to supply precursor through the discharge conduit (22) and the discharge channel (6) and arranged to divide
the discharge conduit (22) to two discharge sub-conduits on opposite sides of the precursor supply channel (10, 10') and
the discharge channel (6) in the longitudinal direction to a first discharge sub-channel (7) and a second discharge sub-channel (9) on opposite sides of the precursor supply channel (10, 10').

8. A nozzle head (1) according to claim 7, **characterized in that**:
- at least one of the first and second precursor supply channels (10, 10') is arranged inside a discharge channel (6) for dividing the discharge channel (6) in the longitudinal direction to a first discharge sub-channel (7) and a second discharge sub-channel (9) on opposite sides of the precursor supply channel (10, 10'); and/or
- the first and second supply channels (10, 10') are each arranged to supply precursor through a discharge channel (6), or that the first and second supply channels (10, 10') are each arranged inside a discharge channel (6).

9. A nozzle head according to claim 7 or 8, **characterized in that**:
- the first and second precursor supply channels (10, 10') are arranged to extend through the discharge channel (6) to the output face (4) in a direction transversal to the longitudinal direction of the discharge channel (6); or
- the first and second precursor supply channels (10, 10') are arranged to extend inside and along the discharge channel (6); or
- the first and second precursor supply channels (10, 10') are arranged to extend substantially coaxially inside and along the discharge channel (6).

10. A nozzle head according to any one of claims 7 to 9, **characterized in that**:
- the nozzle head (1) further comprises one or more purge gas channels (45, 47) provided between the discharge channels (6) for supplying purge gas to the surface of the substrate (100).

11. A nozzle head according to any one of claims 7 to 10, **characterized in that** the nozzle head (1) further comprises discharge perimeter (5) surrounding the nozzles (8) on the output face (4).

12. A nozzle head according to any one of claims 7 to 11, **characterized in that** the nozzle head comprises one or more nozzles (8) according to claims 1 to 6 for forming one or more precursor supply channels (10, 10') and discharge channels (6).

13. Use of a nozzle according to claims 1 to 6 for subjecting a surface of a substrate to surface reaction a gaseous precursor.

14. Use of a nozzle head according to claims 7 to 12 for subjecting a surface of a substrate to successive surface reactions of at least of first and second gaseous precursor for forming thin film on the surface of the substrate according to the principles of atomic layer deposition.

## Patentansprüche

1. Düse (8), so angeordnet, dass sie die Oberfläche eines Substrats (100) einem gasförmigen Vorläufer aussetzt, wobei die Düse (8) umfasst:
- eine Austrittsfläche (24), über die der Vorläufer zugeführt wird;
- ein Vorläuferzuführelement (30, 50) für die Zuführung des Vorläufers;
- einen längsverlaufenden Ablaufkanal (6), der zur und entlang der Austrittsfläche (24) offen ist, so dass wenigstens ein Teil des Vorläufers, der vom Vorläuferkanal (10) zugeführt wird, abläuft, und
- wenigstens einen Reinigungsgaskanal (45, 47), der zur Austrittsfläche (24) offen ist, wobei die Düse (8) weiterhin einen den Ablaufkanal (6) bildenden Körper (20) umfasst und der Körper weiterhin eine Ablaufleitung (22) umfasst, die sich im Wesentlichen parallel und in Fluidverbindung mit dem Ablaufkanal (6) erstreckt, um ablaufenden Vorläufer aus dem Ablaufkanal (6) austreten zu lassen, dass das Vorläuferzuführelement (30, 50) so angeordnet ist, dass es sich innerhalb des Ablaufkanals (6) in Längsrichtung erstreckt, so dass das Vorläuferzuführelement (30, 50) den Ablaufkanal (6) in Längsrichtung in einen ersten Teil-Ablaufkanal (7) und einen zweiten Teil-Ablaufkanal (9) an gegenüberliegenden Seiten des Vorläuferzuführelements (30, 50) zum Zuführen des Vorläufers über den Ablaufkanal (6) teilt, und dass das Vorläuferzuführelement (30, 50) so angeordnet ist, dass es sich durch die Ablaufleitung (22) erstreckt, so dass der Vorläuferkanal (10) die Ablaufleitung (22) in zwei Teil-Ablaufleitungen an gegenüberliegenden Seiten des Vorläuferzuführelementes (30, 50) teilt.

2. Düse nach Anspruch 1, **dadurch gekennzeichnet, dass** das Vorläuferzuführelement (30, 50) ein integraler Bestandteil des Körpers (20) oder ein separates Teil ist.

3. Düse nach Anspruch 1 oder 2, **dadurch gekennzeichnet, dass** das Vorläuferzuführelement (30, 50) umfasst:
- einen Vorläuferzuführkanal oder mehrere Vorläuferzuführkanäle (10, 14), der bzw. die zur Austrittsfläche (24) offen ist bzw. sind, zum Zuführen des Vorläufers über die Austrittsfläche (24); und/oder
- eine Vorläuferleitung (32, 52) in Fluidverbindung mit dem Vorläuferzuführkanal (10, 14) zum Leiten des Vorläufers zum Vorläuferzuführkanal (10, 14); und/oder
- eine Erweiterung (38) in der Nähe der Austrittsfläche (24) zur Vergrößerung der Breite des längsverlaufenden Vorläuferkanals (10) an der Austrittsfläche (24); und/oder
- ein Vorläuferzuführloch oder mehrere Vorläuferzuführlöcher (14), das bzw. die sich von der Vorläuferleitung (32, 52) erstreckt bzw. erstrecken und zur Austrittsfläche (24) offen ist bzw. sind, um den Vorläuferzuführkanal zu bilden; und/oder
- ein Vorläuferzuführloch oder mehrere Vorläuferzuführlöcher (14), das bzw. die sich von der Vorläuferleitung (32, 52) erstreckt bzw. erstrecken und zur Austrittsfläche (24) offen ist bzw. sind, um den Vorläuferzuführkanal zu bilden, die Vorläuferzuführlöcher (14) bilden dabei die Zuführkanäle, oder die Vorläuferzuführlöcher (14) erstrecken sich zwischen der Vorläuferleitung (32, 52) und dem längsverlaufenden Vorläuferzuführkanal (10), der zur und entlang der Austrittsfläche (24) offen ist.

4. Düse nach einem der Ansprüche 1 bis 3, **dadurch gekennzeichnet, dass:**
- das Vorläuferzuführelement (30, 50) sich durch den Ablaufkanal (6) zur Austrittsfläche (24) erstreckt; oder
- das Vorläuferzuführelement (30) sich durch die Ablaufleitung (22) und den Ablaufkanal (6) zur Austrittsfläche (24) erstreckt, so dass der Vorläuferkanal (10) die Ablaufleitung (22) in zwei Teil-Ablaufleitungen an gegenüberliegenden Seiten des Vorläuferzuführelements (30, 50) aufteilt.

5. Düse nach einem der Ansprüche 1 bis 4, **dadurch gekennzeichnet, dass:**
- das Vorläuferzuführelement (50) sich innerhalb der Ablaufleitung (22) erstreckt und somit eine Fluidverbindung zwischen dem ersten und dem zweiten Teil-Ablaufkanal (7, 9) herstellt; und/oder
- das Vorläuferzuführelement (30, 50) so angeordnet ist, dass es sich innerhalb des Ablaufkanals (6) erstreckt, so dass die Stirnfläche (34) des Zuführelements (30, 50) im Wesentlichen bündig mit der Austrittsfläche (24) ist.

6. Düse nach Anspruch 1, **dadurch gekennzeichnet, dass** der Vorläuferzuführkanal (10) und der Ablaufkanal (6) innerhalb des Reinigungsgaskanals (45, 47) so angeordnet sind, dass der Vorläuferzuführkanal (10) und der Ablaufkanal (6) den Reinigungsgaskanal (44, 47) in einen ersten und einen zweiten Teil-Reinigungsgaskanal (53, 54) an gegenüberliegenden Seiten des Ablaufkanals (6) und des Vorläuferzuführkanals (10) aufteilt.

7. Düsenkopf (1), um eine Oberfläche eines Substrats (100) aufeinanderfolgenden Oberflächenreaktionen von wenigstens einem ersten gasförmigen Vorläufer und einem zweiten gasförmigen Vorläufer auszusetzen, wobei der Düsenkopf (1) eine Austrittsfläche (4) hat und umfasst:
- einen ersten längsverlaufenden Vorläuferzuführkanal oder mehrere erste längsverlaufende Vorläuferzuführkanäle (10), um eine Oberfläche eines Substrats (100) dem ersten Vorläufer über die Austrittsfläche (4) auszusetzen; und
- einen zweiten längsverlaufenden Vorläuferzuführkanal oder mehrere zweite längsverlaufende Vorläuferzuführkanäle (10), um eine Oberfläche eines Substrats (100) dem zweiten Vorläufer über die Austrittsfläche (4) auszusetzen, und
- einen längsverlaufenden Ablaufkanal oder mehrere längsverlaufende Ablaufkanäle (6), der bzw. die zur Austrittsfläche (4) offen ist bzw. sind, so dass wenigstens ein Teil des ersten und zweiten Vorläufers, die von den ersten und zweiten Vorläuferzuführkanälen (10, 10) zugeführt werden, abläuft, und
einen oder mehrere Reinigungsgaskanäle (45, 47) zum Zuführen von Reinigungsgas zur Oberfläche des Substrats (100),
**dadurch gekennzeichnet, dass** der Düsenkopf (1) eine oder mehrere Düsen (8) umfasst, wobei eine Düse (8) einen Düsenkörper (20) und ein Vorläuferzuführelement (30) umfasst, der Düsenkörper (20) einen Ablaufkanal (6) und eine Ablaufleitung (22), die im Wesentlichen parallel und in Fluidverbindung mit dem Ablaufkanal (6) verläuft, so dass der Vorläufer aus dem Ablaufkanal (6) austritt, umfasst, und
das Vorläuferzuführelement (30) den einen längsverlaufenden Vorläuferzuführkanal oder die mehreren längsverlaufenden Vorläuferzuführkanäle (10, 10') umfasst, und dass
wenigstens einer der ersten und zweiten Vorläuferzuführkanäle (10, 10') angeordnet ist zum Zuführen von Vorläufer durch die Ablaufleitung (22) und durch den Ablaufkanal (6) und angeordnet ist zum Teilen
der Ablaufleitung (22) in zwei Teil-Ablaufleitungen an gegenüberliegenden Seiten des Vorläuferzuführkanals (10, 10') und
des Ablaufkanals (6) in Längsrichtung in einen ersten Teil-Ablaufkanal (7) und einen zweiten Teil-Ablaufkanal (9) an gegenüberliegenden Seiten des Vorläuferzuführkanals (10, 10').

8. Düsenkopf (1) nach Anspruch 7, **dadurch gekennzeichnet, dass:**
- wenigstens einer der ersten und zweiten Vorläuferzuführkanäle (10, 10') innerhalb eines Ablaufkanals (6) so angeordnet ist, dass er den Ablaufkanal (6) in Längsrichtung in einen ersten Teil-Ablaufkanal (7) und einen zweiten Teil-Ablaufkanal (9) an gegenüberliegenden Seiten des Vorläuferzuführkanals (10, 10') teilt; und/oder
- die ersten und zweiten Zuführkanäle (10, 10') jeweils so angeordnet sind, dass sie Vorläufer durch einen Ablaufkanal (6) zuführen, oder dass die ersten und zweiten Zuführkanäle (10, 10') jeweils innerhalb eines Ablaufkanals (6) angeordnet sind.

9. Düsenkopf nach Anspruch 7 oder 8, **dadurch gekennzeichnet, dass:**
- die ersten und zweiten Vorläuferzuführkanäle (10, 10') so angeordnet sind, dass sie sich durch den Ablaufkanal (6) zur Austrittsfläche (4) quer zur Längsrichtung des Ablaufkanals (6) erstrecken; oder
- die ersten und zweiten Vorläuferzuführkanäle (10, 10') so angeordnet sind, dass sie sich innerhalb und entlang des Ablaufkanals (6) erstrecken; oder
- die ersten und zweiten Vorläuferzuführkanäle (10, 10') so angeordnet sind, dass sie sich im Wesentlichen koaxial innerhalb und entlang des Ablaufkanals (6) erstrecken.

10. Düsenkopf nach einem der Ansprüche 7 bis 9, **dadurch gekennzeichnet, dass:**
- der Düsenkopf (1) weiterhin einen oder mehrere Reinigungsgaskanäle (45, 47) umfasst, die zwischen den Ablaufkanälen (6) zum Zuführen von Reinigungsgas zur Oberfläche des Substrats (100) vorgesehen sind.

11. Düsenkopf nach einem der Ansprüche 7 bis 10, **dadurch gekennzeichnet, dass** der Düsenkopf (1) weiterhin eine Ablaufbegrenzung (5) umfasst, die die Düsen (8) auf der Austrittsfläche (4) umgibt.

12. Düsenkopf nach einem der Ansprüche 7 bis 11, **dadurch gekennzeichnet, dass** der Düsenkopf eine oder mehrere Düse(n) (8) nach den Ansprüchen 1 bis 6 zur Bildung eines Vorläuferzuführkanals oder mehrerer Vorläuferzuführkanäle (10, 10') und eines Ablaufkanals oder mehrerer Ablaufkanäle (6) umfasst.

13. Verwendung einer Düse nach den Ansprüchen 1 bis 6, um eine Oberfläche eines Substrats der Oberflächenreaktion eines gasförmigen Vorläufers auszusetzen.

14. Verwendung eines Düsenkopfs nach den Ansprüchen 7 bis 12, um eine Oberfläche eines Substrats aufeinanderfolgenden Oberflächenreaktionen von wenigstens einem ersten und einem zweiten gasförmigen Vorläufer auszusetzen zur Bildung einer Dünnschicht auf der Oberfläche des Substrats nach den Grundsätzen der Atomlagenabscheidung.

## Revendications

1. Buse (8) agencée de façon à soumettre une surface d'un substrat (100) à un précurseur gazeux, la buse (8) comprenant :
- une face de sortie (24) par l'intermédiaire de laquelle est fourni le
précurseur;
- un élément d'alimentation de précurseur (30, 50) pour fournir le
précurseur;
- un canal d'évacuation longitudinal (6) ouvert vers et le long de la face de sortie (24) pour évacuer au moins une fraction du précurseur fourni à partir du canal de précurseur (10), et
- au moins un canal de gaz de purge (45, 47) ouvert à la face de sortie (24), dans laquelle la buse (8) comprend en outre un corps (20) formant le canal d'évacuation (6), et le corps comprend en outre un conduit d'évacuation (22) s'étendant essentiellement de manière parallèle et en communication fluidique avec le canal d'évacuation (6) pour évacuer le précurseur évacué à partir du canal d'évacuation (6), l'élément d'alimentation de précurseur (30, 50) est agencé de façon à s'étendre de manière longitudinale à l'intérieur du canal d'évacuation (6) de telle sorte que l'élément d'alimentation de précurseur (30, 50) divise le canal d'évacuation (6) suivant la direction longitudinale en un premier sous-canal d'évacuation (7) et un second sous-canal d'évacuation (9) sur des côtés opposés de l'élément d'alimentation de précurseur (30, 50) pour fournir le précurseur à travers le canal d'évacuation (6), et l'élément d'alimentation de précurseur (30, 50) est agencé de façon à s'étendre à travers le conduit d'évacuation (22) de telle sorte que le canal de précurseur (10) divise le conduit d'évacuation (22) en deux sous-conduits d'évacuation sur des côtés opposés de l'élément d'alimentation de précurseur (30, 50).

2. Buse selon la revendication 1, **caractérisée en ce que** l'élément d'alimentation de précurseur (30, 50) fait partie intégrante du corps (20) ou est une partie séparée.

3. Buse selon la revendication1 ou 2, **caractérisée en ce que** l'élément d'alimentation de précurseur (30, 50) comprend :
- un ou plusieurs canaux d'alimentation de précurseur (10, 14) ouverts à la face de sortie (24) pour fournir le précurseur par l'intermédiaire de la face de sortie (24) ; et/ ou
- un conduit de précurseur (32, 52) en connexion fluidique avec le canal d'alimentation de précurseur (10, 14) pour conduire le précurseur au canal d'alimentation de précurseur (10, 14) ; et/ ou
- une extension (38) à proximité de la face de sortie (24) pour augmenter la largeur du canal de précurseur longitudinal (10) au niveau de la face de sortie (24) ; et/ ou
- un ou plusieurs orifices d'alimentation de précurseur (14) s'étendant à partir du conduit de précurseur (32, 52) et s'ouvrant à la face de sortie (24) pour former le canal d'alimentation de précurseur ; et/ ou
- un ou plusieurs orifices d'alimentation de précurseur (14) s'étendant à partir du conduit de précurseur (32, 52) et s'ouvrant à la face de sortie (24) pour former le canal d'alimentation de précurseur, les orifices d'alimentation de précurseur (14) formant les canaux d'alimentation, ou les orifices d'alimentation de précurseur (14) s'étendant entre le conduit de précurseur (32, 52) et le canal d'alimentation de précurseur longitudinal (10) ouvert à et le long de la face de sortie (24).

4. Buse selon l'une quelconque des revendications 1 à 3, **caractérisée en ce que** :
- l'élément d'alimentation de précurseur (30, 50) s'étend à travers le canal d'évacuation (6) à la face de sortie (24) ; ou
- l'élément d'alimentation de précurseur (30) s'étend à travers le conduit d'évacuation (22) et le canal d'évacuation (6) à la face de sortie (24) de telle sorte que le canal de précurseur (10) divise le conduit d'évacuation (22) en deux sous-conduits d'évacuation sur des côtés opposés de l'élément d'alimentation de précurseur (30, 50).

5. Buse selon l'une quelconque des revendications 1 à 4, **caractérisée en ce que** :
- l'élément d'alimentation de précurseur (50) s'étend à l'intérieur du conduit d'évacuation (22) fournissant une connexion fluidique entre les premier et second sous-canaux d'évacuation (7, 9) ; et/ ou
- l'élément d'alimentation de précurseur (30, 50) est agencé de façon à s'étendre à l'intérieur du canal d'évacuation (6) de telle sorte que la face d'extrémité (34) de l'élément d'alimentation (30, 50) est essentiellement au même niveau que la face de sortie (24).

6. Buse selon la revendication 1, **caractérisée en ce que** l'élément d'alimentation de précurseur (10) et le canal d'évacuation (6) sont agencés à l'intérieur du canal de gaz de purge (45, 47) de telle sorte que le canal d'alimentation de précurseur (10) et le canal d'évacuation (6) divisent le canal de gaz de purge (44, 47) en des premier et second sous-canaux de gaz de purge (53, 54) sur des côtés opposés du canal d'évacuation (6) et du canal d'alimentation de précurseur (10).

7. Tête de buse (1) pour soumettre une surface d'un substrat (100) à des réactions de surface successives d'au moins un premier précurseur gazeux et d'un second précurseur gazeux, la tête de buse (1) ayant une face de sortie (4) et comprenant :
- un ou plusieurs premiers canaux d'alimentation de précurseur longitudinaux (10) pour soumettre la surface du substrat (100) au premier précurseur par l'intermédiaire de la face de sortie (4) ; et
- un ou plusieurs seconds canaux d'alimentation de précurseur longitudinaux (10) pour soumettre la surface du substrat (100) au second précurseur par l'intermédiaire de la face de sortie (4), et
- un ou plusieurs canaux d'évacuation longitudinaux (6) ouverts à la face de sortie (4) pour évacuer au moins une fraction des premier et second précurseurs fournis à partir des premier et second canaux d'alimentation (10, 10'), et
un ou plusieurs canaux de gaz de purge (45, 47) pour fournir un gaz de purge à la surface du substrat (100),
**caractérisée en ce que** la tête de buse (1) comprend une ou plusieurs buses (8), dans laquelle une buse (8) comprend un corps de buse (20) et un élément d'alimentation de précurseur (30), le corps de buse (20) comprend un canal d'évacuation (6) et un conduit d'évacuation (22) s'étendant essentiellement de manière parallèle et en communication fluidique avec le canal d'évacuation (6) pour évacuer le précurseur évacué à partir du canal d'évacuation (6), et
l'élément d'alimentation de précurseur (30) comprend le ou les canaux d'alimentation de précurseur longitudinaux (10, 10'), et **en ce que**
au moins un des premier et second canaux d'alimentation de précurseur (10, 10') est agencé pour fournir un précurseur à travers le conduit d'évacuation (22) et le canal d'évacuation (6) et agencé pour diviser
le conduit d'évacuation (22) en deux sous-conduits d'évacuation sur des côtés opposés du canal d'alimentation de précurseur (10, 10') et
le canal d'évacuation (6) suivant la direction longitudinale vers un premier sous-canal d'évacuation (7) et un second sous-canal d'évacuation (9) sur des côtés opposés du canal d'alimentation de précurseur (10, 10').

8. Tête de buse (1) selon la revendication 7, **caractérisée en ce que** :
- au moins un des premier et second canaux d'alimentation de précurseur (10, 10') est agencé à l'intérieur d'un canal d'évacuation (6) pour diviser le canal d'évacuation (6) suivant la direction longitudinale en un premier sous-canal d'évacuation (7) et un second sous-canal d'évacuation (9) sur des côtés opposés du canal d'alimentation de précurseur (10, 10') ; et/ ou
- les premier et second canaux d'alimentation (10, 10') sont chacun agencés de façon à fournir un précurseur à travers un canal d'évacuation (6), ou **en ce que** les premier et second canaux d'alimentation (10, 10') sont chacun agencés à l'intérieur d'un canal d'évacuation (6).

9. Tête de buse selon la revendication 7 ou 8, **caractérisée en ce que** :
- les premier et second canaux d'alimentation de précurseur (10, 10') sont agencés de façon à s'étendre à travers à travers le canal d'évacuation (6) jusqu'à la face de sortie (4) suivant une direction transversale à la direction longitudinale du canal d'évacuation (6) ; ou
- les premier et second canaux d'alimentation de précurseur (10, 10') sont agencés de façon à s'étendre à l'intérieur et le long du canal d'évacuation (6) ; ou
- les premier et second canaux d'alimentation de précurseur (10, 10') sont agencés pour s'étendre essentiellement de manière coaxiale à l'intérieur et le long du canal d'évacuation (6).

10. Tête de buse selon l'une quelconque des revendications 7 à 9, **caractérisée en ce que** :
- la tête de buse (1) comprend en outre un ou plusieurs canaux de gaz de purge (45, 47) disposés entre les canaux d'évacuation (6) pour fournir un gaz de purge à la surface du substrat (100).

11. Tête de buse selon l'une quelconque des revendications 7 à 10, **caractérisée en ce que** la tête de buse (1) comprend en outre un périmètre d'évacuation (5) entourant les buses (8) sur la face de sortie (4).

12. Tête de buse selon l'une quelconque des revendications 7 à 11, **caractérisée en ce que** la tête de buse comprend une ou plusieurs buses (8) selon les revendications 1 à 6 pour former un ou plusieurs canaux d'alimentation de précurseur (10, 10') et canaux d'évacuation (6).

13. Utilisation d'une buse selon les revendications 1 à 6, pour soumettre une surface d'un substrat à une réaction de surface d'un précurseur gazeux.

14. Utilisation d'une tête de buse selon les revendications 7 à 12 pour soumettre une surface d'un substrat à des réactions de surface successives d'au moins un premier précurseur gazeux et un second précurseur gazeux pour former un film mince sur la surface du substrat selon les principes d'une déposition par couche atomique.
